# EUROPEAN PATENT APPLICATION

(11) **EP 4 779 278 A1**
(43) Date of publication of application: **22.07.2026**
(21) Application number: 25226881.8
(22) Date of filing: 23.12.2025
(51) Int. Cl.: G01K 7/18, G01K 7/20

(54) **DEVICE AND METHOD FOR SENSING TEMPERATURE BASED ON RESISTOR-CAPACITOR DIGITAL-TO-ANALOG-CONVERTER**

(30) Priority: 15.01.2025 KR 20250006020
(71) Applicant: Samsung Electronics Co., Ltd., Suwon-si, Gyeonggi-do 16677 (KR)
(72) Inventor: YOUN, Yelim, 16677 Suwon-si (KR); KIM, Wan, 16677 Suwon-si (KR); LIM, Yong, 16677 Suwon-si (KR)
(74) Representative: Marks & Clerk LLP

(57) **Abstract**

A temperature sensing device includes: a first sensing circuit with a first capacitor circuit selectively connected to a first resistor; a second sensing circuit with a second capacitor circuit selectively connected to a second resistor; a comparator circuit configured to output a comparison signal based on a comparison of a first voltage of a first node and a second voltage of a second node; and a successive approximation register (SAR) logic circuit configured to output digital data obtained based on a comparison of the comparison signal in a successive approximation register manner. The first sensing circuit is configured to charge at least one of a plurality of first capacitors with a power supply voltage based on a first control signal, and discharged to a ground voltage through the first resistor and the first node based on a second control signal.

## Description

### BACKGROUND

The present disclosure relates to a temperature sensing device, and more particularly, relates to a resistor-type temperature sensing device using a capacitive digital-to-analog converter (CDAC) and a method of sensing a temperature.

A chip-embedded temperature sensor may be integrated into an integrated circuit to monitor a temperature of a chip. The chip-embedded temperature sensor may be used to protect the chip from being damaged by overheating or to perform calibration based on a temperature such that performance of the chip is maintained.

A resistor-type temperature sensor is a type of temperature sensor which may sense a temperature based on a change in an RC time constant by utilizing a characteristic that a resistance value of a resistive element changes in proportion to a temperature.

### SUMMARY

One or more embodiments provide a resistor-capacitor digital-to-analog converter (resistor-CDAC) based low-power, small-area temperature sensing device.

According to an aspect of an embodiment, a temperature sensing device includes: a first sensing circuit including a first resistor and a first capacitor circuit selectively connected to the first resistor; a second sensing circuit including a second resistor and a second capacitor circuit selectively connected to the second resistor; a comparator circuit configured to output a comparison signal based on a comparison of a first voltage of a first node and a second voltage of a second node; and a successive approximation register (SAR) logic circuit configured to output digital data obtained based on a comparison of the comparison signal in a successive approximation register manner. The first capacitor circuit includes a plurality of first capacitors. The first sensing circuit is configured to charge at least one of the plurality of first capacitors with a power supply voltage based on a first control signal, and discharged to a ground voltage through the first resistor and the first node based on a second control signal. The second capacitor circuit includes a plurality of second capacitors. The second sensing circuit is configured to discharge at least one of the plurality of second capacitors to the ground voltage based on the first control signal, and charged with the power supply voltage through the second resistor and the second node based on the second control signal.

According to another aspect of an embodiment, a temperature sensing method of a temperature sensing device which includes a first sensing circuit including a first resistor and a plurality of first capacitors selectively connected to the first resistor and a second sensing circuit including a second resistor and a plurality of second capacitors selectively connected to the second resistor, the temperature sensing method including: charging at least one of the plurality of first capacitors with a power supply voltage based on a first control signal and discharging at least one of the plurality of second capacitors to a ground voltage based on the first control signal; discharging at least one of the plurality of first capacitors to the ground voltage through the first resistor and a first node based on a second control signal and charging at least one of the plurality of second capacitors with the power supply voltage through the second resistor and a second node based on the second control signal; outputting, at a comparator, a comparison signal based on a comparison of a first voltage of the first node and a second voltage of the second node according to a clock signal; and outputting, at an SAR logic circuit, digital data obtained based on based on a comparison of the comparison signal in a successive approximation register manner.

According to another aspect of an embodiment, a system on chip (SoC) includes: a processor core configured to receive a power supply voltage from a power management integrated circuit; a first sensing circuit including a first resistor whose resistance value linearly changes based on a temperature of the processor core and a first capacitor circuit selectively connected to the first resistor; a second sensing circuit including a second resistor whose resistance value linearly changes based on the temperature of the processor core and a second capacitor circuit selectively connected to the second resistor; a comparator circuit configured to output a comparison signal obtained based on a comparison of a first voltage of a first node and a second voltage of a second node; and an SAR logic circuit configured to output digital data obtained based on a comparison of the comparison signal in a successive approximation register manner. The first capacitor circuit includes a plurality of first capacitors. The first sensing circuit is configured to charge at least one of the plurality of first capacitors with the power supply voltage based on a first control signal, and discharged to a ground voltage through the first resistor and the first node based on a second control signal. The second capacitor circuit includes a plurality of second capacitors. The second sensing circuit is configured to discharge at least one of the plurality of second capacitors to the ground voltage based on the first control signal, and charged with the power supply voltage through the second resistor and the second node based on the second control signal.

At least some of the above and other features of the invention are set out in the claims.

### BRIEF DESCRIPTION OF DRAWINGS

The above and other objects and features will be more apparent from the following description of embodiments, taken in conjunction with the accompanying drawings.
FIG. 1 is a diagram for describing a temperature sensing device according to an embodiment the present disclosure.
FIG. 2 is a circuit diagram for describing a first sensing circuit and a second sensing circuit according to an embodiment.
FIG. 3 is a diagram for describing operations of a first sensing circuit and a second sensing circuit in a first phase according to an embodiment.
FIG. 4 is a diagram for describing operations of a first sensing circuit and a second sensing circuit in a second phase according to an embodiment.
FIG. 5 is a diagram for describing change curves of a first voltage and a second voltage according to phases according to an embodiment.
FIG. 6 is a diagram for describing a voltage change curve based on an RC time constant according to an embodiment.
FIG. 7 is a diagram for describing a comparator according to an embodiment.
FIG. 8 is a diagram for describing an SAR logic circuit according to an embodiment.
FIGS. 9A, 9B, 9C and 9D are diagrams for describing an operation of a temperature sensing device according to an embodiment.
FIG. 10 is a timing diagram for describing an operation of a temperature sensing device according to an embodiment.
FIG. 11 is a flowchart for describing an operation in which a temperature sensing device determines each bit value of temperature code data according to an embodiment.
FIG. 12 is a flowchart for describing an operation of a temperature sensing device according to an embodiment.
FIG. 13 is a diagram for describing a system on chip according to an embodiment.

### DETAILED DESCRIPTION

Below, embodiments of the present disclosure will be described in detail and clearly to such an extent that an ordinary one in the art can easily carry out the present disclosure. Embodiments described herein are example embodiments, and thus, the present disclosure is not limited thereto, and may be realized in various other forms. Each embodiment provided in the following description is not excluded from being associated with one or more features of another example or another embodiment also provided herein or not provided herein but consistent with the present disclosure.

A temperature sensing device 10 may generate temperature code data TCODE by digitizing analog temperature information based on a change in an RC time constant caused when a resistance value of a resistor having a proportional to absolute temperature (PTAT) characteristic and a capacitance value of a capacitor digital-to-analog converter (CDAC) change.

The RC time constant indicates a time taken for an RC circuit including a resistor and a capacitor to reach a specific voltage. The RC time constant may be associated with charging and discharging times of the RC circuit. The RC time constant may be expressed as τ = R x C (where R is the circuit resistance and C is the circuit capacitance), and a voltage change curve of the RC circuit may be in the form of an exponential function.

The temperature sensing device 10 may measure (i.e., identify) a temperature based on a crossing point time of output voltage change curves (corresponding to a first voltage VIP and a second voltage VIM) according to RC time constants of a plurality of sensing circuits 100 and 200, each of the plurality of sensing circuits 100 and 200 including a resistor and a capacitor. The first voltage VIP may be output by first sensing circuit 100 and the second voltage VIM may be output by second sensing circuit 200.

In detail, the temperature sensing device 10 may search for the crossing point on the voltage change curve by sequentially controlling capacitance values of the plurality of sensing circuits 100 and 200 in a successive approximation register (SAR) manner. The temperature sensing device 10 may output the temperature code data TCODE as digital data associated with temperature information obtained by digitizing the analog temperature information based on the found (i.e., identified) crossing point time.

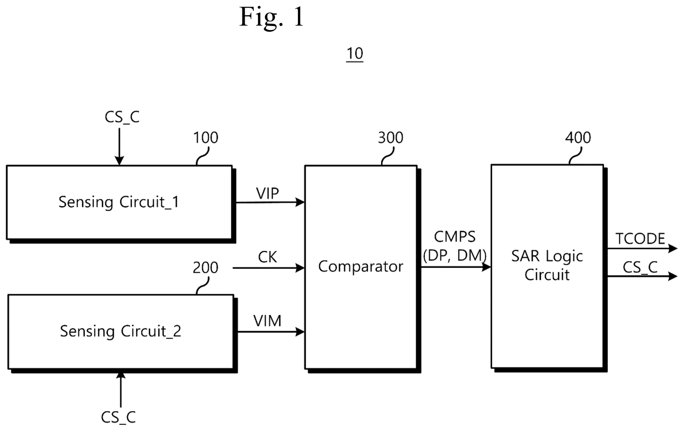

FIG. 1 is a diagram for describing the temperature sensing device 10 according to an embodiment.

Referring to FIG. 1, the temperature sensing device 10 may include the first sensing circuit 100, the second sensing circuit 200, a comparator (e.g., comparator circuit) 300, and an SAR logic circuit 400.

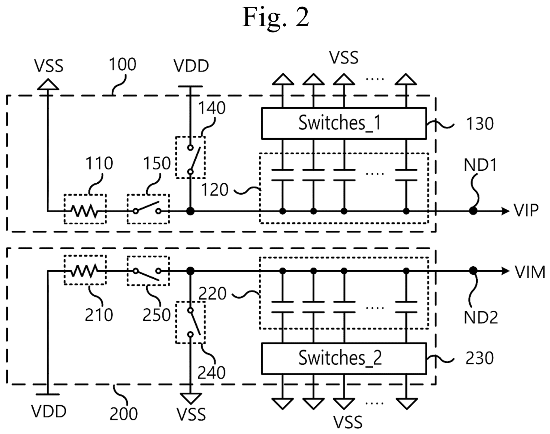

The first sensing circuit 100 may output the first voltage VIP so as to be provided to the comparator 300. For example, the first sensing circuit 100 may include a first resistor 110 (refer to FIG. 2) whose resistance value linearly changes depending on a temperature (e.g., depending on a temperature of the first resistor 110). In this case, the first voltage VIP may be generated based on a change in a resistance value according to the temperature of the first resistor 110. Accordingly, the first voltage VIP may be an analog signal including information about (e.g., indicating) the temperature of the first resistor 110.

The second sensing circuit 200 may output the second voltage VIM so as to be provided to the comparator 300. For example, the second sensing circuit 200 may include a second resistor 210 (refer to FIG. 2) whose resistance value linearly changes depending on a temperature (e.g., depending on a temperature of the second resistor 210). In this case, the second voltage VIM may be generated based on a change in a resistance value according to the temperature of the second resistor 210. Accordingly, the second voltage VIM may be an analog signal including information about (e.g., indicating) the temperature of the second resistor 210.

The comparator 300 may receive the first voltage VIP and the second voltage VIM. The comparator 300 may compare the first voltage VIP and the second voltage VIM and may output a comparison signal CMPS based on a comparison result. In this case, the comparator 300 may output the comparison signal CMPS based on (e.g., in response to) a clock signal CK. The comparison signal CMPS may be provided to the SAR logic circuit 400.

For example, when the first voltage VIP is greater than the second voltage VIM, the comparator 300 may output a first comparison signal DM as the comparison signal CMPS. In contrast, when the second voltage VIM is greater than the first voltage VIP, the comparator 300 may output a second comparison signal DP as the comparison signal CMPS.

The SAR logic circuit 400 may receive the comparison signal CMPS. The SAR logic circuit 400 may generate and output a third control signal CS_C and the temperature code data TCODE based on the comparison signal CMPS.

The third control signal CS_C may be a signal for controlling the first sensing circuit 100 based on the comparison signal CMPS. In detail, the third control signal CS_C may control the first sensing circuit 100 to control the first voltage VIP.

For example, the first sensing circuit 100 may include a plurality of first capacitors 120 (refer to FIG. 2) and a plurality of first switches 130 (refer to FIG. 2) for controlling the plurality of first capacitors 120. In this case, the third control signal CS_C may control a switching operation of the plurality of first switches 130 to change a capacitance value of the plurality of first capacitors 120. According to the above description, the RC time constant of the first sensing circuit 100 may change based on the third control signal CS_C such that the first voltage VIP is controlled.

The third control signal CS_C may be a signal for controlling the second sensing circuit 200 based on the comparison signal CMPS. In detail, the third control signal CS_C may control the second sensing circuit 200 to control the second voltage VIM.

For example, the second sensing circuit 200 may include a plurality of second capacitors 220 (refer to FIG. 2) and a plurality of second switches 230 (refer to FIG. 2) for controlling the plurality of second capacitors 220. In this case, the third control signal CS_C may control a switching operation of the plurality of second switches 230 to change a capacitance value of the plurality of second capacitors 220. According to the above description, the RC time constant of the second sensing circuit 200 may change based on the third control signal CS_C such that the second voltage VIM is controlled.

As a result, the third control signal CS_C may control the crossing point of the voltage curves of the first voltage VIP and the second voltage VIM, which is based on RC time constant changes of the first voltage VIP and the second voltage VIM, based on the comparison signal CMPS.

In detail, the RC time constant change may control a speed of the process of charging or discharging the first sensing circuit 100 and the second sensing circuit 200. Accordingly, when the RC time constant changes, the voltage change curves of the first voltage VIP and the second voltage VIM may change. In this case, based on the changed RC time constant, the crossing point of the voltage change curves of the first voltage VIP and the second voltage VIM may move. That is, the temperature sensing device 10 may measure a temperature based on the change of the crossing point.

The temperature code data TCODE may be generated based on the comparison signal CMPS. The temperature code data TCODE may be data obtained by digitizing the analog temperature information which is based on the RC time constant changes of the first sensing circuit 100 and the second sensing circuit 200.

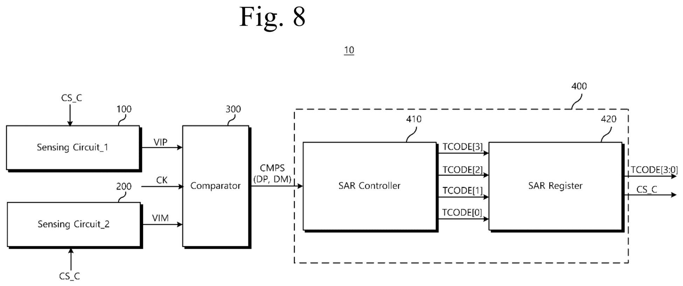

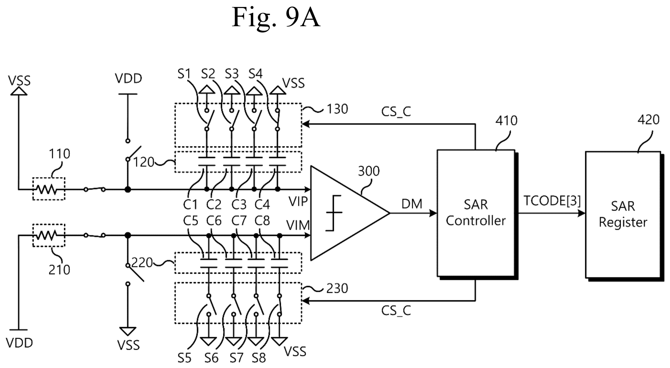

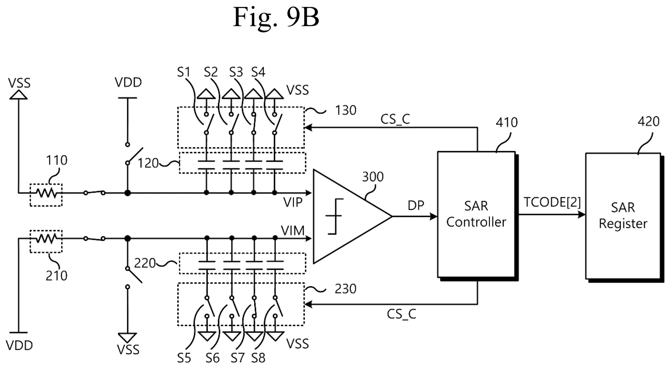

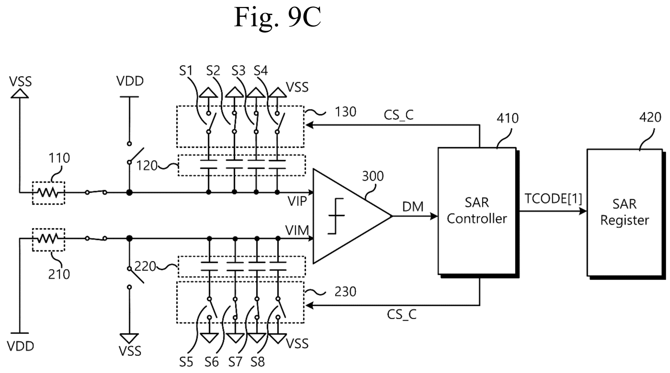

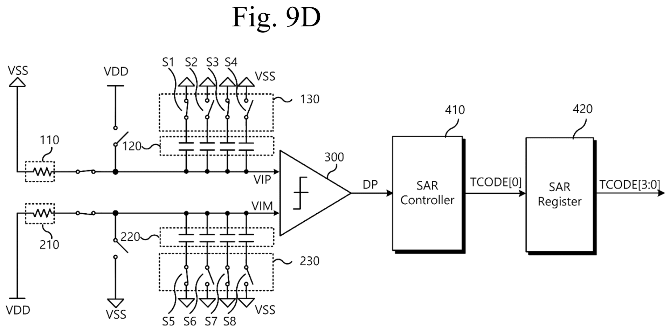

Each bit value of the temperature code data TCODE may be generated based on the successive approximation register manner. A successive approximation register (SAR) process is an analog-to-digital conversion (ADC) technique that uses a binary search algorithm to convert an analog input voltage into a discrete digital representation. This is achieved by iteratively adjusting capacitance of a digital-to-analog converter (DAC) that is controlled by the SAR logic circuit. In this regard, each bit value of the temperature code data TCODE may be generated by sequentially controlling the first voltage VIP and the second voltage VIM based on the comparison signal CMPS. The generation of each bit of the temperature code data TCODE, the control of the first voltage VIP, and the control of the second voltage VIM may be sequentially repeated. Finally, the temperature code data TCODE may be output after all bit values are generated. Below, the process will be described in detail with reference to FIGS. 8 and 9.

As described above, the temperature sensing device 10 may output the temperature code data TCODE by digitizing the analog temperature information based on the change in the RC time constant. Because the temperature sensing device 10 does not include a circuit component requiring a high voltage, the temperature sensing device 10 may be capable of being driven even at a low power supply voltage. Because the temperature sensing device 10 is capable of sensing a temperature by digitizing the RC time constant by using capacitors not sensitive to a temperature change, there is not required an additional operation such as calibration according to a temperature change. Accordingly, it may be possible to implement the temperature sensing device 10 which reduces power consumption and occupies the small area.

FIG. 2 is a circuit diagram for describing the first sensing circuit 100 and the second sensing circuit 200 according to the present disclosure.

Referring to FIG. 2, the first sensing circuit 100 may include the first resistor 110, the plurality of first capacitors 120, the plurality of first switches 130, a first control switch 140, and a second control switch 150.

The first resistor 110 may be a resistive element having a PTAT characteristic. That is, the first resistor 110 may be a resistive element having a characteristic that a resistance value increases at a given ratio (e.g., at a predefined rate) when a temperature increases and decreases at the given ratio (e.g., at the predefined rate) when the temperature decreases.

A ground voltage VSS may be applied to a first end of the first resistor 110, and a second end of the first resistor 110 may be electrically connected to the second control switch 150. Accordingly, when the second control switch 150 is turned on to enter a second phase, in this regard, when the plurality of first capacitors 120 are discharged to the ground voltage VSS, the first resistor 110 may act as a cause of changing the RC time constant.

That is, when a temperature changes, the resistance value of the first resistor 110 may change; in this case, a discharging time of the voltage change curve of the first voltage VIP may change.

The plurality of first capacitors 120 may include capacitors, the number of which is the same as the number of bits of the temperature code data TCODE. In this case, the plurality of first capacitors 120 may be configured to have different capacitance values.

For example, when the temperature code data TCODE includes four bits, the plurality of first capacitors 120 may include four capacitors having capacitances of 1C, 2C, 4C, and 8C. That is, the capacitance of each capacitor may be proportional to 2ⁿ, where n represents the number for that capacitor.

First plates (e.g., top plates) of the plurality of first capacitors 120 may be electrically connected to a first node ND1. Second plates (e.g. bottom plates) of the plurality of first capacitors 120 may be electrically connected to the plurality of first switches 130.

In detail, a total capacitance value of the plurality of first capacitors 120 may be controlled based on a switching operation of the plurality of first switches 130, which is based on the third control signal CS_C. The total capacitance value of the plurality of first capacitors 120 may affect the RC time constant. Accordingly, the first voltage VIP (e.g., the voltage at the first node ND1) may be controlled based on a change in the total capacitance value of the plurality of first capacitors 120.

The plurality of first switches 130 may include switches, the number of which is the same as the number of the plurality of first capacitors 120. For example, when the plurality of first capacitors 120 include four capacitors, the plurality of first switches 130 may include four switches.

The plurality of first switches 130 may include first ends electrically connected to the plurality of first capacitors 120 and second ends to which the ground voltage VSS is applied. The plurality of first switches 130 may be turned on or turned off based on the third control signal CS_C. For example, one of the plurality of first switches 130 may be connected between one of the plurality of first capacitors 120 and the ground voltage VSS, and another one of the plurality of first switches 130 may be connected between another one of the plurality of first capacitors 120 and the ground voltage VSS. A charge state of each capacitor connected to each of the plurality of first switches 130 may be controlled based on the switching operation of the plurality of first switches 130.

Accordingly, the total capacitance value of the plurality of first capacitors 120 may be changed based on the switching operation of the plurality of first switches 130.

In detail, when a specific first switch is turned on, a capacitor electrically connected to the specific first switch may be connected to the ground voltage VSS; in this case, the capacitor may operate as a part of the RC circuit and may be added to the total capacitance value. In contrast, when the specific first switch is turned off, the capacitor electrically connected to the specific first switch may be incapable of operating as a part of the RC circuit and may not be added to the total capacitance value.

As a result, the total capacitance value of the plurality of first capacitors 120 may be controlled based on the switching operation of the plurality of first switches 130, and the first voltage VIP may be controlled through the control of the capacitance value.

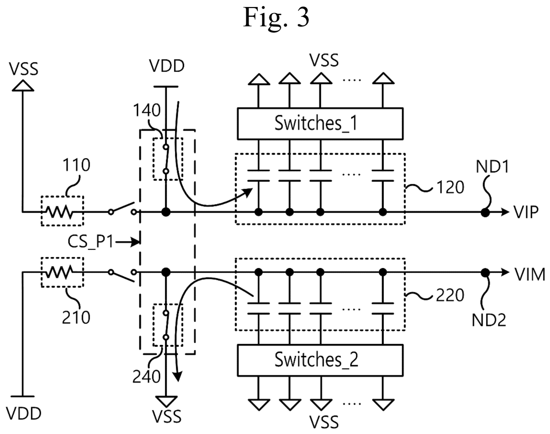

A power supply voltage VDD may be applied to a first end of the first control switch 140, and a second end of the first control switch 140 may be electrically connected to the first node ND1. The first control switch 140 may be controlled based on a first control signal CS_P1 (refer to FIG. 3).

For example, the first control switch 140 may be turned on when the first control signal CS_P1 is at a high level. In this case, because the first node ND1 is connected to the power supply voltage VDD, in a first phase, the plurality of first capacitors 120 may be charged with the power supply voltage VDD.

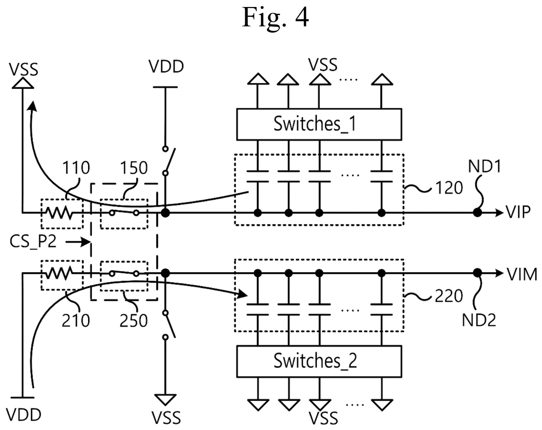

A first end of the second control switch 150 may be electrically connected to the first resistor 110, and a second end of the second control switch 150 may be electrically connected to the first node ND1. The second control switch 150 may be controlled based on a second control signal CS_P2 (refer to FIG. 4).

For example, the second control switch 150 may be turned on when the second control signal CS_P2 is at a high level. In this case, because the first node ND1 is connected to the ground voltage VSS and the first resistor 110, in the second phase, the plurality of first capacitors 120 may be discharged to the ground voltage VSS. In this case, the discharging speed of the plurality of first capacitors 120 may change depending on the resistance value of the first resistor 110 according to a temperature and the total capacitance value of the plurality of first capacitors 120.

Referring to FIG. 2, the second sensing circuit 200 may include the second resistor 210, the plurality of second capacitors 220, the plurality of second switches 230, a third control switch 240, and a fourth control switch 250. Because a configuration of the second sensing circuit 200 is the same as or very similar to the configuration of the first sensing circuit 100, the description which is the same as or similar to the description of the first sensing circuit 100 will be omitted to avoid redundancy.

The second resistor 210 may be a resistive element having a PTAT characteristic similar to that of the first resistor 110. That is, the second resistor 210 may be a resistive element having a characteristic that a resistance value increases at a given ratio (e.g., at a predefined rate) when a temperature increases and decreases at the given ratio (e.g., at the predefined rate) when the temperature decreases. The given ratio corresponding to the first resistor 110 may be the same as the given ratio corresponding to the second resistor 210.

The power supply voltage VDD may be applied to a first end of the second resistor 210, and a second end of the second resistor 210 may be electrically connected to the fourth control switch 250. Accordingly, when the fourth control switch 250 is turned on to enter the second phase, in this regard, when the plurality of second capacitors 220 are charged with the power supply voltage VDD, the second resistor 210 may act as a cause of changing the RC time constant.

That is, when a temperature changes, the resistance value of the second resistor 210 may change; in this case, a charging time of the voltage change curve of the second voltage VIM may change.

The plurality of second capacitors 220 may include capacitors, the number of which is the same as the number of bits of the temperature code data TCODE. The plurality of second capacitors 220 may be configured to have different capacitance values.

First plates (e.g. top plates) of the plurality of second capacitors 220 may be electrically connected to a second node ND2. Second plates (e.g., bottom plates) of the plurality of second capacitors 220 may be electrically connected to the plurality of second switches 230.

In detail, a total capacitance value of the plurality of second capacitors 220 may be controlled based on a switching operation of the plurality of second switches 230, which is based on the third control signal CS_C. The total capacitance value of the plurality of second capacitors 220 may affect the RC time constant. Accordingly, the second voltage VIM (e.g., the voltage at the second node ND2) may be controlled based on a change in the capacitance value of the plurality of second capacitors 220.

The plurality of second switches 230 may include switches, the number of which is the same as the number of the plurality of second capacitors 220.

The plurality of second switches 230 may include first ends electrically connected to the plurality of second capacitors 220 and second ends to which the ground voltage VSS is applied. The plurality of second switches 230 may be turned on or turned off based on the third control signal CS_C. For example, one of the plurality of second switches 230 may be connected between one of the plurality of second capacitors 220 and the ground voltage VSS, and another one of the plurality of second switches 230 may be connected between another one of the plurality of second capacitors 220 and the ground voltage VSS. A charge state of each capacitor connected to each of the plurality of second switches 230 may be controlled based on the switching operation of the plurality of second switches 230.

Accordingly, the total capacitance value of the plurality of second capacitors 220 may be changed based on the switching operation of the plurality of second switches 230.

The ground voltage VSS may be applied to a first end of the third control switch 240, and a second end of the third control switch 240 may be electrically connected to the second node ND2. The third control switch 240 may be controlled based on the first control signal CS_P1.

For example, the third control switch 240 may be turned on when the first control signal CS_P1 is at a high level. In this case, because the second node ND2 is connected to the ground voltage VSS, in the first phase, the plurality of second capacitors 220 may be discharged to the ground voltage VSS.

A first end of the fourth control switch 250 may be electrically connected to the second resistor 210, and a second end of the fourth control switch 250 may be electrically connected to the second node ND2. The fourth control switch 250 may be controlled based on the second control signal CS_P2.

For example, the fourth control switch 250 may be turned on when the second control signal CS_P2 is at a high level. In this case, because the second node ND2 is connected to the power supply voltage VDD and the second resistor 210, in the second phase, the plurality of second capacitors 220 may be charged with the power supply voltage VDD. In this case, the charging speed of the plurality of second capacitors 220 may change depending on the resistance value of the second resistor 210 according to a temperature and the total capacitance value of the plurality of second capacitors 220.

The first resistor 110 and the second resistor 210 may be resistive elements having the same resistance value. The first resistor 110 and the second resistor 210 may be thermally coupled to each other such that they have the same temperature. Accordingly, the resistance values of the first resistor 110 and the second resistor 210 may have change identically with temperature. The first resistor 110 and the second resistor 210 may be configured to be thermally coupled to a target whose temperature is to be sensed. Accordingly, resistance values of the first resistor 110 and the second resistor 210 may identically change based on a temperature of the target whose temperature will be sensed.

The plurality of first capacitors 120 and the plurality of second capacitors 220 may include the same number of capacitors. Also, the capacitance of each of the plurality of first capacitors 120 may be the same as the capacitance of each of the plurality of second capacitors 220. In this regard, the plurality of first capacitors 120 and the plurality of second capacitors 220 may be implemented in a symmetrical structure having the same configuration.

FIG. 3 is a diagram for describing operations of the first sensing circuit 100 and the second sensing circuit 200 in a first phase according to an example embodiment.

Referring to FIG. 3, the first control switch 140 and the third control switch 240 may be controlled based on the first control signal CS_P1.

For example, the first control switch 140 and the third control switch 240 may be turned on when the first control signal CS_P1 is at a high level. In this case, the first sensing circuit 100 and the second sensing circuit 200 may operate in the first phase based on the first control switch 140 and the third control switch 240 being turned on.

In the first phase, the power supply voltage VDD may be applied to the plurality of first capacitors 120, and thus, the plurality of first capacitors 120 may be charged.

For example, the first control switch 140 may be turned on by the first control signal CS_P1, and thus, the power supply voltage VDD may be applied to the first node ND1. According to the above description, a current flow may be induced, and thus, a voltage of the first node ND1 may gradually approach the power supply voltage VDD. Also, charges may start to be accumulated in the plurality of first capacitors 120.

In detail, the power supply voltage VDD applied to the first node ND1 may be provided to the first plates (e.g., the top plates) of the plurality of first capacitors 120, and thus, a potential difference may be formed between the plates of the plurality of first capacitors 120. Charges may be accumulated in proportion to the capacitance of the plurality of first capacitors 120, based on the potential difference.

When the process of charging the plurality of first capacitors 120 is completed, the voltage of the first node ND1 may be the same as the power supply voltage VDD. Accordingly, in the first phase, the power supply voltage VDD may be finally output as the first voltage VIP.

In the first phase, the ground voltage VSS may be applied to the plurality of second capacitors 220, and thus, the plurality of second capacitors 220 may be discharged.

For example, the third control switch 240 may be turned on by the first control signal CS_P1, and thus, the ground voltage VSS may be applied to the second node ND2. According to the above description, a current flow may be induced, and thus, a voltage of the second node ND2 may gradually approach the ground voltage VSS. Also, the charges accumulated in the plurality of second capacitors 220 may start to be discharged.

In detail, the ground voltage VSS applied to the second node ND2 may be provided to the first plates (e.g., the top plates) of the plurality of second capacitors 220, and thus, a potential difference between the plates of the plurality of second capacitors 220 may decrease. Charges accumulated in the plurality of second capacitors 220 may be discharged based on the decrease in the potential difference.

When the process of discharging the plurality of second capacitors 220 is completed, the voltage of the second node ND2 may be the same as the ground voltage VSS. Accordingly, in the first phase, the ground voltage VSS may be finally output as the second voltage VIM.

FIG. 4 is a diagram for describing operations of the first sensing circuit 100 and the second sensing circuit 200 in a second phase according to an example embodiment.

Referring to FIG. 4, the second control switch 150 and the fourth control switch 250 may be controlled based on the second control signal CS_P2.

For example, the second control switch 150 and the fourth control switch 250 may be turned on when the second control signal CS_P2 is at a high level. In this case, the first sensing circuit 100 and the second sensing circuit 200 may operate in the second phase based on the second control switch 150 and the fourth control switch 250 being turned on.

In the second phase, the ground voltage VSS may be applied to the plurality of first capacitors 120 through the first resistor 110, and thus, the plurality of first capacitors 120 may be discharged.

For example, the second control switch 150 may be turned on by the second control signal CS_P2, and thus, the ground voltage VSS may be applied to the first node ND1 through the first resistor 110. According to the above description, a voltage of the first node ND1 may gradually approach the ground voltage VSS. Also, charges charged in the plurality of first capacitors 120 may start to be discharged.

In detail, the ground voltage VSS applied to the first node ND1 may be provided to the first plates (e.g., the top plates) of the plurality of first capacitors 120 through the first resistor 110, and thus, a potential difference between the plates of the plurality of first capacitors 120 may decrease. Charges accumulated in the plurality of first capacitors 120 may be discharged based on the decrease in the potential difference.

As the process of discharging the plurality of first capacitors 120 progresses, the voltage of the first node ND1, that is, the first voltage VIP also approaches the ground voltage VSS. In this case, the discharging speed of the first voltage VIP may vary based on the RC time constant of the first sensing circuit 100, which is determined based on the product of the capacitance value of the plurality of first capacitors 120 and the resistance value of the first resistor 110. As discussed above, the resistance of the first resistor 110 increases at a given ratio when a temperature increases and decreases at the given ratio when the temperature decreases. Therefore, the RC time constant increases as the temperature increases, and decreases as the temperature decreases.

For example, as the RC time constant becomes smaller, the discharging speed may become higher. In contrast, as the RC time constant becomes greater, the discharging speed may become lower.

As a result, in the second phase, the first voltage VIP may exponentially decrease over time and may gradually approach the ground voltage VSS.

In the second phase, the power supply voltage VDD may be applied to the plurality of second capacitors 220 through the second resistor 210, and thus, the plurality of second capacitors 220 may be charged.

For example, the fourth control switch 250 may be turned on by the second control signal CS_P2, and thus, the power supply voltage VDD may be applied to the second node ND2 through the second resistor 210. According to the above description, a voltage of the second node ND2 may gradually approach the power supply voltage VDD. Also, charges may start to be charged in the plurality of second capacitors 220.

In detail, the power supply voltage VDD applied to the second node ND2 may be provided to the first plates (e.g., the top plates) of the plurality of second capacitors 220 through the second resistor 210, and thus, a potential difference may be formed between the plates of the plurality of second capacitors 220. Charges may be accumulated in proportion to the capacitance of the plurality of second capacitors 220, based on the potential difference.

As the process of charging the plurality of second capacitors 220 progresses, the voltage of the second node ND2, that is, the second voltage VIM also approaches the power supply voltage VDD. In this case, the charging speed of the second voltage VIM may vary based on the RC time constant of the second sensing circuit 200, which is determined based on the product of the capacitance value of the plurality of second capacitors 220 and the resistance value of the second resistor 210. As discussed above, the resistance of the second resistor 210 increases at a given ratio when a temperature increases and decreases at the given ratio when the temperature decreases. Therefore, the RC time constant increases as the temperature increases, and decreases as the temperature decreases.

For example, as the RC time constant becomes smaller, the charging speed may become higher. In contrast, as the RC time constant becomes greater, the charging speed may become lower.

As a result, in the second phase, the second voltage VIM may exponentially increase over time and may gradually approach the power supply voltage VDD.

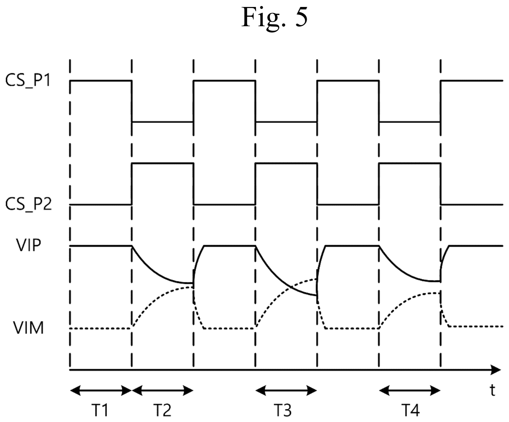

FIG. 5 is a diagram for describing change curves of the first voltage VIP and the second voltage VIM according to phases according to an embodiment. Below, the description which is the same as or similar to the description given with reference to FIGS. 1 to 4 will be omitted to avoid redundancy.

The first control signal CS_P1 may be provided as a signal of a square shape. In this regard, the first control signal CS_P1 may be a signal whose waveform transitions to "high" and "low" alternatively and repeatedly with a given period (e.g., at a given frequency).

The second control signal CS_P2 may also be provided as a signal of a square shape and may be a signal whose waveform transitions to "high" and "low" alternately and repeatedly with a given period (e.g., at a given frequency).

The first control signal CS_P1 and the second control signal CS_P2 may have different levels in at least a portion of the same time interval. Accordingly, the first phase and the second phase may be alternately repeated. For instance, the second control signal CS_P2 may be the inverse of the first control signal CSP1.

In FIG. 5, T1 indicates a first period of the first phase. During the T1 interval, the first voltage VIP may be charged to the power supply voltage VDD, and the second voltage VIM may be discharged to the ground voltage VSS.

In FIG. 5, T2 indicates a first period of the second phase. During the T2 interval, the first voltage VIP decreases, and the second voltage VIM increases; in this case, a voltage change curve of each of the first voltage VIP and the second voltage VIM is shown. The voltage change curve of the first voltage VIP may show an exponentially decreasing shape, and the voltage change curve of the second voltage VIM may show an exponentially increasing shape.

In this case, a speed at which the first voltage VIP decreases may change based on the capacitance value of the plurality of first capacitors 120 and the resistance of the first resistor 110. Also, a speed at which the second voltage VIM increases may change based on the capacitance value of the plurality of second capacitors 220 and the resistance of the second resistor 210.

In FIG. 5, T3 indicates a second period of the second phase. In detail, T3 may be a period of the second phase after the capacitance values of the plurality of first capacitors 120 and the plurality of second capacitors 220 are controlled (e.g., changed) by the third control signal CS_C.

When the capacitance values of the plurality of first capacitors 120 and the plurality of second capacitors 220 are controlled (e.g., changed), the RC time constants of the first sensing circuit 100 and the second sensing circuit 200 may change. As a result, the voltage decreasing speed of the first voltage VIP may be different from T2. Also, the voltage increasing speed of the second voltage VIM may be different from T2.

In FIG. 5, T4 indicates a third period of the second phase. Because T4 also is based on the change in the RC time constants of the first sensing circuit 100 and the second sensing circuit 200, the voltage decreasing speed of the first voltage VIP and the voltage increasing speed of the second voltage VIM may be different from T2 and T3.

As described above, when the capacitance values of the plurality of first capacitors 120 and the plurality of second capacitors 220 are controlled, the RC time constant values of the first sensing circuit 100 and the second sensing circuit 200 may change. In each period of the second phase, the voltage decreasing curve of the first voltage VIP and the voltage increasing curve of the second voltage VIM may change based on the change in the RC time constant values.

As a result, the temperature sensing device 10 may sense a temperature based on a change in a voltage curve which is based on a change in an RC time constant value and may generate the temperature code data TCODE.

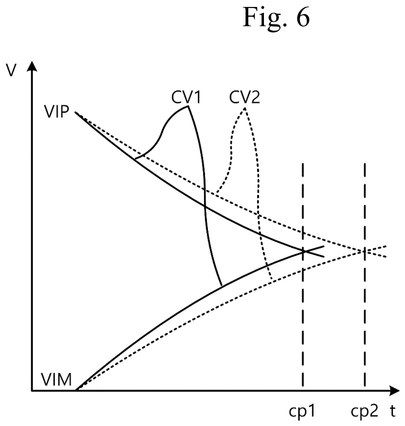

FIG. 6 is a diagram for describing a voltage change curve based on an RC time constant according to an embodiment.

Referring to FIG. 6, a voltage change curve CV1 indicates the case where the RC time constant is small, and a voltage change curve CV2 indicates the case where the RC time constant is great. That is, the RC time constant is smaller for the voltage change curve CV1 than for the voltage change curve CV2.

Referring to the voltage change curve CV1 and the voltage change curve CV2, voltage change speeds according to charging and discharging are different from each other based on an RC time constant difference. The RC time constant difference may depend on resistance values of the first resistor 110 and the second resistor 210, which vary according to a temperature difference, and capacitance values of the plurality of first capacitors 120 and the plurality of second capacitors 220.

The RC time constant value for the first sending circuit 100 may be determined based on the resistance value of the first resistor 110 and the capacitance value of the plurality of first capacitors 120, and the RC time constant value for the second sensing circuit 200 may be determined based on the resistance value of the second resistor 210 and the capacitance value of the plurality of second capacitors 220. The RC time constant difference may be determined based on the resistance value of the first resistor 110 and the capacitance value of the plurality of first capacitors 120, and based on the resistance value of the second resistor 210 and the capacitance value of the plurality of second capacitors 220. The resistance values of the first resistor 110 and the second resistor 210 may change depending on a temperature. As a result, the RC time constant values of the first sensing circuit 100 and the second sensing circuit 200 may change depending on a temperature.

For example, at a high temperature, because the resistance values of the first resistor 110 and the second resistor 210 are great, the RC time constant value may be great, and thus, the voltage change speeds according to charging and discharging may be slow. In this case, voltage change curves of the first voltage VIP and the second voltage VIM at the high temperature may be the same as the voltage change curve CV2.

In contrast, at a low temperature, because the resistance values of the first resistor 110 and the second resistor 210 are small, the RC time constant value may be small, and thus, the voltage change speeds according to charging and discharging may be fast. In this case, voltage change curves of the first voltage VIP and the second voltage VIM at the low voltage may be the same as the voltage change curve CV1.

As the first sensing circuit 100 and the second sensing circuit 200 have similar configurations, and assuming that the switches of both circuits are controlled to turn on the same selections of capacitors, the first sensing circuit 100 and second sensing circuit 200 should have the same RC time constant value, for matching temperature. The RC time constant value(s) may be determined based on the resistance value of the first resistor 110 and the capacitance value of the plurality of first capacitors 120, and the resistance value of the second resistor 210 and the plurality of second capacitors 220. Unlike the resistance values of the first resistor 110 and the second resistor 210, the capacitance values of the plurality of first capacitors 120 and the plurality of second capacitors 220 may not change depending on a temperature. Instead, the capacitance values of the plurality of first capacitors 120 and the plurality of second capacitors 220 may be controlled by the third control signal CS_C and thus may change. As a result, the RC time constant values of the first sensing circuit 100 and the second sensing circuit 200 may be controlled by the third control signal CS_C.

For example, when the capacitance values of the plurality of first capacitors 120 and the plurality of second capacitors 220 are great, the RC time constant value may be great, and thus, the voltage change speeds according to charging and discharging may be slow. In this case, voltage change curves of the first voltage VIP and the second voltage VIM may be the same as the voltage change curve CV2.

In contrast, when the capacitance values of the plurality of first capacitors 120 and the plurality of second capacitors 220 are small, the RC time constant value may be small, and thus, the voltage change speeds according to charging and discharging may be fast. In this case, voltage change curves of the first voltage VIP and the second voltage VIM may be the same as the voltage change curve CV1.

The crossing point indicates a crossing point of two voltage change curves. That is, the crossing point indicates a time point at which voltage values of two voltage change curves are equal. The crossing point may be determined based on the RC time constant value. Accordingly, a crossing point cp1 and a crossing point cp2 of FIG. 6 may be determined based on a temperature difference and/or the capacitance values of the plurality of first capacitors 120 and the plurality of second capacitors 220.

The temperature sensing device 10 may control the crossing point of the voltage change curves of the first voltage VIP and the second voltage VIM and may generate the temperature code data TCODE based on the control of the crossing point.

In detail, the temperature sensing device 10 may dynamically control the crossing point formed based on resistance values of the first resistor 110 and the second resistor 210 according to an initial temperature. Also, the dynamic control of the crossing point may be performed by dynamically controlling the capacitance values of the plurality of first capacitors 120 and the plurality of second capacitors 220.

For example, the temperature sensing device 10 may control the capacitance values of the plurality of first capacitors 120 and the plurality of second capacitors 220 based on the successive approximation register manner (e.g., the successive approximation register method) such that the crossing point is formed at a comparison timing of the comparator 300. In this case, the SAR logic circuit 400 may control the capacitance values of the plurality of first capacitors 120 and the plurality of second capacitors 220 by outputting the third control signal CS_C based on the comparison signal CMPS of the comparator 300. The SAR logic circuit 400 may perform a binary search to control the capacitance of the first capacitors 120 and the second capacitors 220 until the crossing point occurs at the same time (or a similar time) as the comparison timing of the comparator 300. Each time the capacitance is adjusted, the step size of the adjustment may be halved.

As a result, the first voltage VIP may be controlled based on the capacitance value of the plurality of first capacitors 120 thus controlled. Also, the second voltage VIM may be controlled based on the capacitance value of the plurality of second capacitors 220 thus controlled. The comparator 300 may sequentially output the comparison signal CMPS by comparing the first voltage VIP and the second voltage VIM sequentially controlled as described above.

As described above, the temperature sensing device 10 may convert a temperature, which is sensed based on the first and second resistors 110 and 210 whose resistance values vary depending on a temperature, into the temperature code data TCODE. In this case, the temperature sensing device 10 may control the crossing point by controlling the capacitance values of the plurality of first capacitors 120 and the plurality of second capacitors 220 based on the third control signal CS_C. In addition, the temperature sensing device 10 may change the temperature sensed through the control of the crossing point into the temperature code data TCODE. In this case, the capacitance values of the plurality of first capacitors 120 and the plurality of second capacitors 220 may not change depending on a temperature.

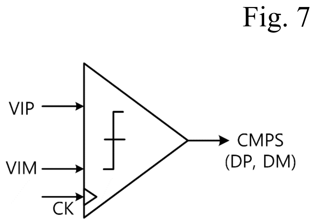

FIG. 7 is a diagram for describing the comparator 300 according to an embodiment.

Referring to FIG. 7, the comparator 300 may receive the first voltage VIP, the second voltage VIM, and the clock signal CK. The comparator 300 may compare the first voltage VIP and the second voltage VIM, and may generate output the comparison signal CMPS based on a comparison result. The comparator 300 may include a latch comparator.

For example, when the first voltage VIP is greater than the second voltage VIM, the comparator 300 may generate and output the first comparison signal DP as the comparison signal CMPS. In contrast, when the second voltage VIM is greater than the first voltage VIP, the comparator 300 may generate and output the second comparison signal DM as the comparison signal CMPS.

The clock signal CK may control the generation of the first comparison signal DP and the second comparison signal DM. In detail, the comparator 300 may compare the first voltage VIP and the second voltage VIM based on (e.g., in response to) the clock signal CK and may generate the first comparison signal DP or the second comparison signal DM based on a comparison result.

For example, the comparator 300 may compare the first voltage VIP and the second voltage VIM at the rising edge of the clock signal CK and may generate the first comparison signal DP or the second comparison signal DM.

FIG. 8 is a diagram for describing SAR logic circuit 400 according to an embodiment.

Referring to FIG. 8, the SAR logic circuit 400 may include an SAR controller (e.g., SAR control circuit) 410 and an SAR register (e.g., SAR register circuit) 420.

The SAR controller 410 may receive the comparison signal CMPS and may generate and output the third control signal CS_C and each bit value of the temperature code data TCODE based on the successive approximation register manner.

The successive approximation register manner may sequentially compare analog input signals and may generate digital data based on a comparison result. For example, the successive approximation register manner may sequentially determine respective bits from a most significant bit (MSB) to a least significant bit (LSB). In this case, an initial MSB value may be set to "1", and the remaining bit values may be set to "0". Final digital data may be generated by repeating the process of controlling a next bit up to the LSB based on a comparison result of each bit.

Based on the successive approximation register manner, the SAR controller 410 may operate differently based on whether the received comparison signal CMPS is the first comparison signal DP or the second comparison signal DM.

For example, when the comparison signal CMPS is the first comparison signal DP, the SAR controller 410 may fix a value of a current bit to "1" and may save the value of the current bit to the SAR register 420, and then, the SAR controller 410 may set an initial value of a next bit to "1". In this case, the third control signal CS_C may be a signal which controls switching operations of the plurality of first switches 130 and the plurality of second switches 230 to control the capacitance values of the plurality of first capacitors 120 and the plurality of second capacitors 220 to decrease. As a result, the charging and discharging speeds of the voltage change curves of the first voltage VIP and the second voltage VIM may become faster, and thus, the crossing point may be advanced.

When the comparison signal CMPS is the second comparison signal DM, the SAR controller 410 may change a value of a current bit to "0" and may save the value of the current bit to the SAR register 420, and then, the SAR controller 410 may set an initial value of a next bit "1". In this case, the third control signal CS_C may be a signal which controls switching operations of the plurality of first switches 130 and the plurality of second switches 230 to control the capacitance values of the plurality of first capacitors 120 and the plurality of second capacitors 220 to increase. As a result, the charging and discharging speeds of the voltage change curves of the first voltage VIP and the second voltage VIM may become slower, and thus, the crossing point may be delayed.

The process in which the SAR controller 410 determines each bit value may be repeated as much as the number of bits of the temperature code data TCODE. The SAR controller 410 may generate and output the third control signal CS_C in the process of determining each bit value, and thus, the capacitance values of the plurality of first capacitors 120 and the plurality of second capacitors 220 may be dynamically controlled. As the first voltage VIP and the second voltage VIM are controlled based on the capacitance values of the plurality of first capacitors 120 and the plurality of second capacitors 220 thus controlled, a next comparison signal CMPS may be determined.

The SAR register 420 may save the bit value which the SAR controller 410 determines. For example, the SAR register 420 may include at least one flip-flop and may save the bit value. Also, when all the bit values are determined and saved, the SAR register 420 may output the temperature code data TCODE being a result of reading the saved bit values in parallel.

For example, when the temperature code data TCODE are 4-bit temperature code data, the SAR register 420 may output the temperature code data TCODE[3:0] being a result of reading data TCODE[0], TCODE[1], TCODE[2], and TCODE[3] of the saved bits in parallel.

The SAR register 420 may further include an initialization circuit for initializing previously saved data to generate and output new temperature code data TCODE after the temperature code data TCODE are output.

In an initial phase of the successive approximation register manner, the SAR controller 410 may set the MSB value to "1" and may set the remaining bit values to "0". Afterwards, the SAR controller 410 may determine the MSB value based on the comparison signal CMPS and may set a next bit value. In this case, the determined MSB value may be saved to the SAR register 420.

Also, the SAR controller 410 may generate and output the third control signal CS_C for controlling the capacitance values of the plurality of first capacitors 120 and the plurality of second capacitors 220 based on the comparison signal CMPS. The capacitance values may be controlled by controlling switching operations of the plurality of first switches 130 and the plurality of second switches 230. The first voltage VIP and the second voltage VIM may be controlled based on the third control signal CS_C, and a next comparison signal CMPS may be generated. Afterwards, a value of a next bit may be determined based on the next comparison signal CMPS.

For each bit, the comparison signal CMPS may be generated, the value of the bit may be determined (and saved) based on the comparison signal CMPS, the third control signal CS_C may be output to adjust the capacitance for the sensing for the next bit.

When the LSB value is determined by repeating the process, in which the SAR controller 410 determines each bit value, as much as the number of bits of the temperature code data TCODE, the SAR register 420 may output the temperature code data TCODE being a result of reading the saved bit values in parallel. After the temperature code data TCODE are output, the SAR register 420 may initialize the saved data to save next data.

As described above, the SAR logic circuit 400 may sequentially determine each bit value based on the successive approximation register manner and may output the third control signal CS_C and the temperature code data TCODE.

FIGS. 9A to 9D are diagrams for describing an operation of the temperature sensing device 10 according to an embodiment. Below, the description which is the same as or similar to the description given with reference to FIGS. 1 to 8 will be omitted to avoid redundancy.

Referring to FIG. 9A, the case where the temperature sensing device 10 outputs the 4-bit temperature code data TCODE is illustrated. Below, the description will be given as the temperature code data TCODE are 4-bit temperature code data, but embodiments are not limited thereto. For example, the temperature code data TCODE may be 10-bit temperature code data.

The plurality of first capacitors 120 may include four capacitors C1, C2, C3, and C4. The four capacitors C1, C2, C3, and C4 may have different capacitances. The capacitances may increase from the first capacitor C1 to the fourth capacitor C4.

The plurality of second capacitors 220 may include four capacitors C5, C6, C7, and C8. The four capacitors C5, C6, C7, and C8 may have different capacitances. The capacitances may increase from the fifth capacitor C5 to the eighth capacitor C8.

The plurality of first switches 130 may include four switches S1, S2, S3, and S4. The four switches S1, S2, S3, and S4 may be controlled by the third control signal CS_C.

The plurality of second switches 230 may include four switches S5, S6, S7, and S8. The four switches S5, S6, S7, and S8 may be controlled by the third control signal CS_C.

In a first period of the second phase, the switch S4 and the switch S8 may be turned on. That is, in the temperature code data TCODE[3:0], an initial MSB value may be set to "1", and the remaining bit values may be set to "0".

Referring to FIG. 9A, the comparator 300 may generate and output the second comparison signal DM as a first comparison signal CMPS. In this case, the SAR controller 410 may change a value of the MSB TCODE[3] of the temperature code data TCODE[3:0] to "0" so as to be saved to the SAR register 420. Also, the SAR controller 410 may generate and output the third control signal CS_C to control the plurality of first switches 130 and the plurality of second switches 230.

Referring to FIG. 9B, the comparator 300 may generate and output the first comparison signal DP as a second comparison signal CMPS. In this case, the switch S4 may be turned off by the third control signal CS_C, and the switch S3 may be turned on by the third control signal CS_C. Accordingly, as the capacitance value of the plurality of first capacitors 120 is controlled, a value of the first voltage VIP may be controlled. Also, the switch S8 may be turned off by the third control signal CS_C, and the switch S7 may be turned on by the third control signal CS_C. Accordingly, as the capacitance value of the plurality of second capacitors 220 is controlled, a value of the second voltage VIM may be controlled.

The comparator 300 may generate and output a second comparison signal DP by comparing the first voltage VIP and the second voltage VIM thus controlled. In this case, the SAR controller 410 may fix a value of the second upper bit TCODE[2] of the temperature code data TCODE[3:0] to "1" so as to be saved to the SAR register 420. Also, the SAR controller 410 may generate and output the third control signal CS_C to control the plurality of first switches 130 and the plurality of second switches 230.

Referring to FIG. 9C, the comparator 300 may generate and output the second comparison signal DM as a third comparison signal CMPS. In this case, the switch S2 may be turned on by the third control signal CS_C. Accordingly, as the capacitance value of the plurality of first capacitors 120 is controlled, a value of the first voltage VIP may be controlled. Also, the switch S6 may be turned on by the third control signal CS_C. Accordingly, as the capacitance value of the plurality of second capacitors 220 is controlled, a value of the second voltage VIM may be controlled.

The comparator 300 may generate and output a third comparison signal DM by comparing the first voltage VIP and the second voltage VIM thus controlled. In this case, the SAR controller 410 may change a value of the third upper bit TCODE[1] of the temperature code data TCODE[3:0] to "0" so as to be saved to the SAR register 420. Also, the SAR controller 410 may generate and output the third control signal CS_C to control the plurality of first switches 130 and the plurality of second switches 230.

Referring to FIG. 9D, the comparator 300 may generate and output the first comparison signal DP as a fourth comparison signal CMPS. In this case, the switch S2 may be turned off by the third control signal CS_C, and the switch S1 may be turned on by the third control signal CS_C. Accordingly, as the capacitance value of the plurality of first capacitors 120 is controlled, a value of the first voltage VIP may be controlled. Also, the switch S6 may be turned off by the third control signal CS_C, and the switch S5 may be turned on by the third control signal CS_C. Accordingly, as the capacitance value of the plurality of second capacitors 220 is controlled, a value of the second voltage VIM may be controlled.

The comparator 300 may generate and output a fourth comparison signal DP by comparing the first voltage VIP and the second voltage VIM thus controlled. In this case, the SAR controller 410 may fix a value of the LSB TCODE[0] of the temperature code data TCODE[3:0] to "1" so as to be saved to the SAR register 420.

When all the bit values of the temperature code data TCODE[3:0] up to the LSB value are determined, the SAR register 420 may output the temperature code data TCODE[3:0] being a result of reading the saved bit values TCODE[3], TCODE[2], TCODE[1], and TCODE[0] in parallel.

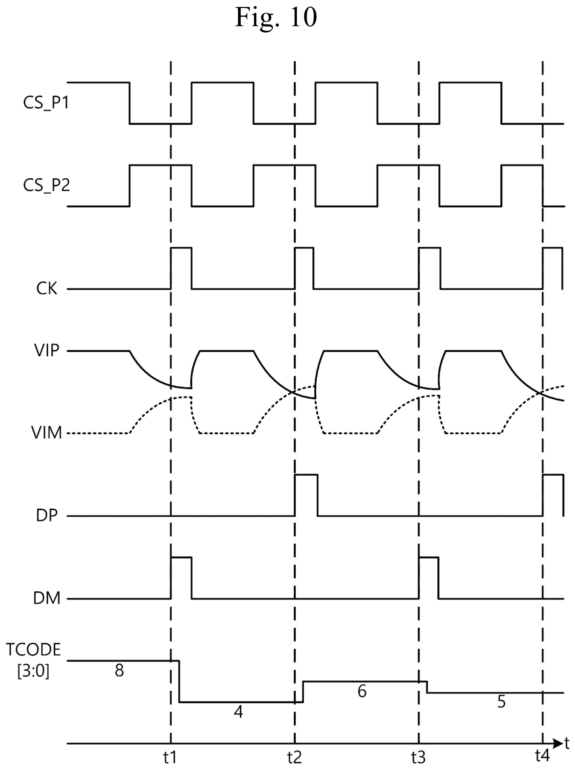

FIG. 10 is a timing diagram for describing an operation of the temperature sensing device 10 according to an embodiment.

Referring to FIG. 10, initially, a value of the MSB TCODE[3] of the temperature code data TCODE[3:0] may be set to "1", and the remaining bit values thereof may be set to "0"; in this case, the temperature code data TCODE[3:0] may have a value of "8" in decimal.

At a time point t1, the comparator 300 may compare the first voltage VIP and the second voltage VIM based on the clock signal CK and may generate and output the second comparison signal DM based on a comparison result. In this case, the SAR controller 410 may change a value of the MSB TCODE[3] of the temperature code data TCODE[3:0] to "0" so as to be saved to the SAR register 420. Also, a value of the second upper bit TCODE[2] may be set to "1", and thus, the temperature code data TCODE[3:0] may have a value of "4" in decimal.

At a time point t2, the comparator 300 may compare the first voltage VIP and the second voltage VIM based on the clock signal CK and may generate and output the first comparison signal DP based on a comparison result. In this case, the SAR controller 410 may fix a value of the second upper bit TCODE[2] of the temperature code data TCODE[3:0] to "1" so as to be saved to the SAR register 420. Also, a value of the third upper bit TCODE[1] may be set to "1", and thus, the temperature code data TCODE[3:0] may have a value of "6" in decimal.

At a time point t3, the comparator 300 may compare the first voltage VIP and the second voltage VIM based on the clock signal CK and may generate and output the second comparison signal DM based on a comparison result. In this case, the SAR controller 410 may change a value of the third upper bit TCODE[1] of the temperature code data TCODE[3:0] to "0" so as to be saved to the SAR register 420. Also, a value of the LSB TCODE[0] may be set to "1", and thus, the temperature code data TCODE[3:0] may have a value of "5" in decimal.

At a time point t4, the comparator 300 may compare the first voltage VIP and the second voltage VIM based on the clock signal CK and may generate and output the first comparison signal DP based on a comparison result. In this case, the SAR controller 410 may fix a value of the LSB TCODE[0] of the temperature code data TCODE[3:0] to "1" so as to be saved to the SAR register 420. When all the bit values of the temperature code data TCODE[3:0] are determined, the SAR register 420 may output the temperature code data TCODE[3:0] being a result of reading the saved bit values in parallel. In this case, the temperature code data TCODE[3:0] may have a value of "5" in decimal.

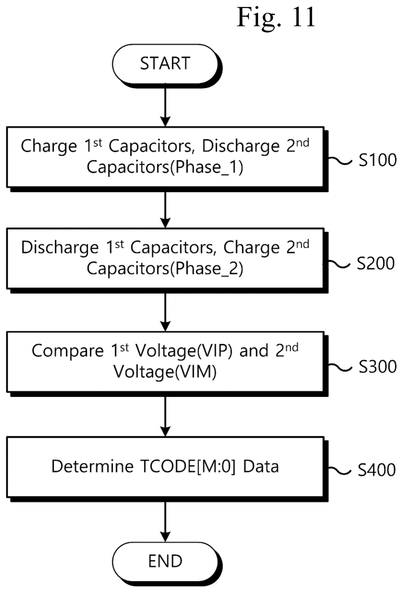

FIG. 11 is a flowchart for describing an operation in which the temperature sensing device 10 determines each bit value of the temperature code data TCODE according to an embodiment.

Referring to FIG. 11, in operation S100, the plurality of first capacitors 120 may be charged with the power supply voltage VDD based on the first control signal CS_P1, and the plurality of second capacitors 220 may be discharged to the ground voltage VSS based on the first control signal CS_P1. Operation S100 may correspond to the first phase.

In operation S200, the plurality of first capacitors 120 may be discharged to the ground voltage VSS based on the second control signal CS_P2, and the plurality of second capacitors 220 may be charged with the power supply voltage VDD based on the second control signal CS_P2. According to the above description, the first voltage VIP and the second voltage VIM may change. Operation S200 may correspond to the second phase.

In operation S300, the comparator 300 may compare the first voltage VIP and the second voltage VIM and may generate the comparison signal CMPS based on a comparison result so as to be output to the SAR controller 410. The comparison signal CMPS may be the first comparison signal DP or the second comparison signal DM.

In operation S400, the SAR controller 410 may determine each bit value of temperature code data TCODE[M:0] based on the comparison signal CMPS, so as to be saved to the SAR register 420.

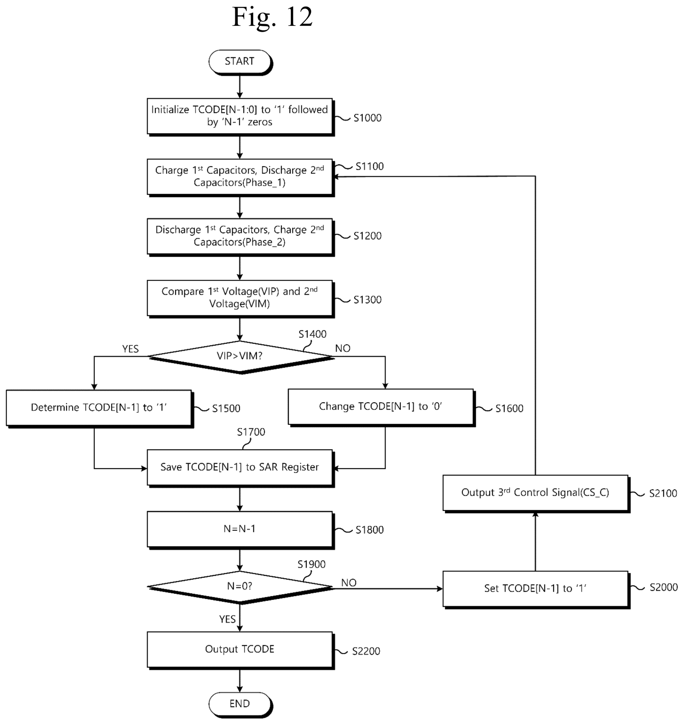

FIG. 12 is a flowchart for describing an operation of the temperature sensing device 10 according to an embodiment. Below, the description which is the same as or similar to the description given with reference to FIGS. 1 to 11 will be omitted to avoid redundancy.

Referring to FIG. 12, in operation S1000, an MSB value of N-bit temperature code data TCODE[N-1:0] may be initialized to "1", and the remaining bit values thereof may be initialized to "0". For example, when N is 4, the temperature code data TCODE[3:0] may be 4-bit data. In this case, the temperature code data TCODE[3:0] may be initialized to have data of "1000". The SAR controller 410 may generate and output the third control signal CS_C for controlling the plurality of first capacitors 120 and the plurality of second capacitors 220. The third control signal CS_C may be set based on the temperature code data TCODE[3:0].

In operation S1100, the plurality of first capacitors 120 may be charged with the power supply voltage VDD, and the plurality of second capacitors 220 may be discharged to the ground voltage VSS. Operation S1100 may correspond to the first phase.

In operation S1200, the plurality of first capacitors 120 may be discharged to the ground voltage VSS, and the plurality of second capacitors 220 may be charged with the power supply voltage VDD. According to the above description, the first voltage VIP and the second voltage VIM may change. Operation S1200 may correspond to the second phase.

In operation S1300, the comparator 300 may compare the first voltage VIP and the second voltage VIM. For example, the comparator 300 may compare the first voltage VIP and the second voltage VIM at the rising edge of the clock signal CK.

When a comparison result in operation S1400 indicates that the first voltage VIP is greater than the second voltage VIM (YES in operation S1400), in operation S1500, the SAR controller 410 may determine a value of the MSB TCODE[N-1] of the temperature code data TCODE[N-1:0] as "1". That is, when the comparator 300 outputs the first comparison signal DP, the value of the MSB TCODE[N-1] of the temperature code data TCODE[N-1:0] may be determined as "1".

When the comparison result in operation S1400 indicates that the first voltage VIP is equal to or smaller than the second voltage VIM (NO in operation S1400), in operation S1600, the SAR controller 410 may determine a value of the MSB TCODE[N-1] of the temperature code data TCODE[N-1:0] as "0". That is, when the comparator 300 outputs the second comparison signal DM, the value of the MSB TCODE[N-1] of the temperature code data TCODE[N-1:0] may be changed and determined to "0".

In operation S1700, the SAR controller 410 may save the determined value of the MSB TCODE[N-1] of the temperature code data TCODE[N-1:0] to the SAR register 420.

In operation S1800, "N" may be changed to "N-1" for the sequential bit value determining process based on the successive approximation register manner.

When the changed value of "N" is not "0" in operation S1900 (NO in operation S1900), in operation S2000, the SAR controller 410 may set a next bit value to "1".

In operation S2100, the SAR controller 410 may generate and output the third control signal CS_C for controlling the plurality of first capacitors 120 and the plurality of second capacitors 220. The third control signal CS_C may be set according to the updated temperature code data TCODE set in S2000. The capacitance values of the plurality of first capacitors 120 and the plurality of second capacitors 220 may be controlled based on the third control signal CS_C, and operation S1100 to operation S2100 may be repeated until N = 0. That is, the temperature sensing device 10 may repeat operation S1100 to operation S2100 until all the bit values of the temperature code data TCODE are determined.

When the changed value of "N" is "0" in operation S1900 (YES in operation S1900), in operation S2200, the SAR register 420 may output the temperature code data TCODE being a result of reading the saved bit values in parallel.

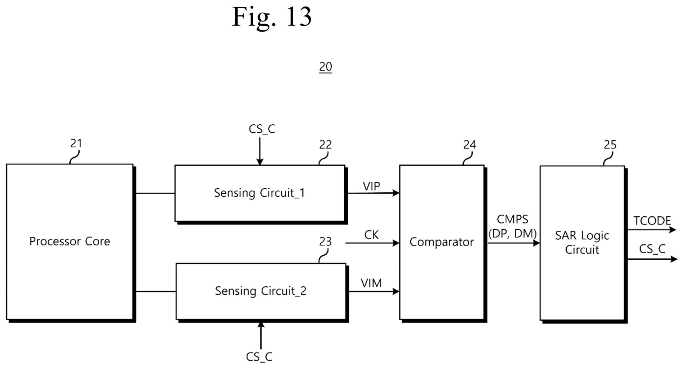

FIG. 13 is a diagram for describing a system on chip 20 according to an embodiment. Below, the description which is the same as or similar to the description given with reference to FIGS. 1 to 12 will be omitted to avoid redundancy.

Referring to FIG. 13, the system on chip 20 may include a processor core (e.g., processor core circuit) 21, a first sensing circuit 22, a second sensing circuit 23, a comparator (e.g., comparator circuit) 24, and a SAR logic circuit 25. The system on chip 20 may further include components different from the above components.

The processor core 21 may include a central processing unit (CPU), an application processor (AP), etc. The processor core 21 may process a program or data stored in an external memory. The processor core 21 may be implemented with a multi-core processor including two or more independent actual processors. The processor core 21 may be provided with the power supply voltage VDD from a power management integrated circuit.

The first sensing circuit 22 and the second sensing circuit 23 may output the first voltage VIP and the second voltage VIM based on a temperature of the processor core 21. The first sensing circuit 22 and the second sensing circuit 23 may output the first voltage VIP and the second voltage VIM by using the power supply voltage VDD with which the processor core 21 is provided.

The comparator 24 may compare the first voltage VIP and the second voltage VIM based on the clock signal CK and may generate output the comparison signal CMPS based on a comparison result. The comparison signal CMPS may be the first comparison signal DP or the second comparison signal DM. The comparator 24 according to an embodiment may be provided with the clock signal CK from a temperature compensated oscillator such as a temperature compensated crystal oscillator (TCXO). In this case, the system on chip 20 may be provided with the clock signal CK in which there are no frequency fluctuations according to a temperature change, and thus, the accuracy of temperature measurement of the system on chip 20 may be improved.

The SAR logic circuit 25 may generate and output the third control signal CS_C and the temperature code data TCODE based on the comparison signal CMPS. The temperature code data TCODE may be data obtained by digitizing information about analog temperatures of the processor core 21, which the first sensing circuit 22 and the second sensing circuit 23 sense.

The first sensing circuit 22, the second sensing circuit 23, the comparator 24, and the SAR logic circuit 25 may be disposed adjacent to the processor core 21 to sense a temperature of the processor core 21 or may be embedded in the processor core 21. For instance, the first sensing circuit 22 and the second sensing circuit 23 may be thermally coupled to the processor core 21. For instance, the first resistor 110 and the second resistor 210 may be thermally coupled to the processor core 21. That is, when the temperature of the processor core 21 changes, the temperatures of the first resistor 110 and the second resistor 210 may also change. The temperature of the first resistor 110 and the temperature of the second resistor 210 may be proportional to the temperature of the processor core 21.

The system on chip 20 may monitor the temperature of the processor core 21 by sensing the temperature of the processor core 21. The system on chip 20 may be used to protect the processor core 21 from being damaged by overheating due to a temperature rise or may be used for calibration for maintaining the performance of the processor core 21 depending on a temperature.

One or more embodiments provide a device for sensing a temperature that may operate at a low supply voltage to reduce power consumption and may be implemented with the small area.

Embodiments are set out in the following Clauses:
Clause 1. A system on chip (SoC) comprising:
   a processor core configured to receive a power supply voltage from a power management integrated circuit;
   a first sensing circuit comprising a first resistor whose resistance value linearly changes based on a temperature of the processor core and a first capacitor circuit selectively connected to the first resistor;
   a second sensing circuit comprising a second resistor whose resistance value linearly changes based on the temperature of the processor core and a second capacitor circuit selectively connected to the second resistor;
   a comparator circuit configured to output a comparison signal obtained based on a comparison of a first voltage of a first node and a second voltage of a second node; and
   a successive approximation register (SAR) logic circuit configured to output digital data obtained based on a comparison of the comparison signal in a successive approximation register manner,
   wherein the first capacitor circuit comprises a plurality of first capacitors,
   wherein the first sensing circuit is configured to charge at least one of the plurality of first capacitors with the power supply voltage based on a first control signal, and discharged to a ground voltage through the first resistor and the first node based on a second control signal,
   wherein the second capacitor circuit comprises a plurality of second capacitors, and
   wherein the second sensing circuit is configured to discharge at least one of the plurality of second capacitors to the ground voltage based on the first control signal, and charged with the power supply voltage through the second resistor and the second node based on the second control signal.
Clause 2. The system on chip of Clause 1, wherein each of the first resistor and the second resistor have a common resistance value at a common temperature,
   wherein a number of capacitors included in the plurality of first capacitors is equal to a number of capacitors included in the plurality of second capacitors, and
   wherein a capacitance of each of the plurality of first capacitors is equal to a capacitance of each of the plurality of second capacitors.
Clause 3. The system on chip of Clause 1 or Clause 2, wherein the SAR logic circuit is further configured to:
   based on the first voltage being greater than the second voltage, output a third control signal to control capacitance values of the first capacitor circuit and the second capacitor circuit to decrease; and
   based on the second voltage is greater than the first voltage, output the third control signal to control the capacitance values of the first capacitor circuit and the second capacitor circuit to increase.
Clause 4. The system on chip of any of Clauses 1-3, wherein the first control signal and the second control signal have different levels in at least a portion of a time interval, and
   wherein the first capacitor circuit and the second capacitor circuit perform a charging operation and a discharging operation differently from each other in the at least a portion of the time interval.

While aspects of embodiments have been described with reference to the drawings, it will be apparent to those of ordinary skill in the art that various changes and modifications may be made thereto without departing from the scope of the present disclosure as set forth in the following claims.

## Claims

1. A temperature sensing device comprising:
a first sensing circuit (100) comprising a first resistor (110) and a first capacitor circuit (120) selectively connected to the first resistor (110);
a second sensing circuit (200) comprising a second resistor (210) and a second capacitor circuit (220) selectively connected to the second resistor (210);
a comparator circuit (300) configured to output a comparison signal based on a comparison of a first voltage of a first node (ND1) and a second voltage of a second node; and
a successive approximation register, SAR, logic circuit (400) configured to output digital data obtained based on a comparison of the comparison signal in a successive approximation register manner,
wherein the first capacitor circuit (120) comprises a plurality of first capacitors,
wherein the first sensing circuit (110) is configured to charge at least one of the plurality of first capacitors with a power supply voltage based on a first control signal, and discharge the at least one of the plurality of first capacitors (110) to a ground voltage through the first resistor (110) and the first node (ND1) based on a second control signal,
wherein the second capacitor circuit (220) comprises a plurality of second capacitors, and
wherein the second sensing circuit (200) is configured to discharge at least one of the plurality of second capacitors to the ground voltage based on the first control signal, and charge the at least one of the plurality of second capacitors (210) with the power supply voltage through the second resistor (210) and the second node (ND2) based on the second control signal.

2. The temperature sensing device of claim 1, wherein each of the first resistor (110) and the second resistor (210) have a resistance value that linearly changes depending on a temperature.

3. The temperature sensing device of claim 1 or claim 2, wherein the first resistor (110) and the second resistor (210) have a common resistance value at a common temperature.

4. The temperature sensing device of any preceding claim, wherein a number of the plurality of first capacitors is equal to a number of the plurality of second capacitors, and
wherein a capacitance of each of the plurality of first capacitors is equal to a capacitance of each of the plurality of second capacitors.

5. The temperature sensing device of any preceding claim, wherein the SAR logic circuit (400) is further configured to:
based on the first voltage being greater than the second voltage, output a third control signal to control capacitance values of the first capacitor circuit (120) and the second capacitor circuit (220) to decrease; and
based on the second voltage being greater than the first voltage, output the third control signal to control the capacitance values of the first capacitor circuit (120) and the second capacitor circuit (220) to increase.

6. The temperature sensing device of claim 5, wherein the first sensing circuit (100) comprises a plurality of first switches configured to electrically connect a ground voltage node to the plurality of first capacitors, respectively, and
wherein the second sensing circuit (200) comprises a plurality of second switches configured to electrically connect the ground voltage node to the plurality of second capacitors, respectively.

7. The temperature sensing device of any preceding claim, wherein the first control signal and the second control signal have different levels in at least a portion of a time interval, and
wherein the first capacitor circuit (120) and the second capacitor circuit (220) perform a charging operation and a discharging operation differently from each other in the at least a portion of the time interval.

8. The temperature sensing device of claim 7, wherein the first sensing circuit (100) further comprises:
a first control switch (140) electrically connected between the first node (ND1) and a power supply voltage node, and configured to be turned on or turned off based on the first control signal; and
a second control switch (150) electrically connected between the first resistor (210) and the first node (ND1), and configured to be turned on or turned off based on the second control signal, and
wherein the second sensing circuit (200) further comprises:
a third control switch (240) electrically connected between the second node (ND2) and a ground voltage node, and configured to be turned on or turned off based on the first control signal; and
a fourth control switch (250) electrically connected between the second resistor (210) and the second node (ND2), and configured to be turned on or turned off based on the second control signal.

9. A temperature sensing method of a temperature sensing device which includes a first sensing circuit (100) including a first resistor (110) and a plurality of first capacitors (120) selectively connected to the first resistor (110) and a second sensing circuit (200) including a second resistor (210) and a plurality of second capacitors (220) selectively connected to the second resistor (210), the temperature sensing method comprising:
charging at least one of the plurality of first capacitors (120) with a power supply voltage based on a first control signal and discharging at least one of the plurality of second capacitors (220) to a ground voltage based on the first control signal;
discharging at least one of the plurality of first capacitors (120) to the ground voltage through the first resistor (110) and a first node (ND1) based on a second control signal and charging at least one of the plurality of second capacitors (220) with the power supply voltage through the second resistor (210) and a second node (ND2) based on the second control signal;
outputting, at a comparator (300), a comparison signal based on a comparison of a first voltage of the first node (ND1) and a second voltage of the second node (ND2) according to a clock signal; and
outputting, at a successive approximation register, SAR, logic circuit (400), digital data obtained based on based on a comparison of the comparison signal in a successive approximation register manner.

10. The temperature sensing method of claim 9, wherein:
each of the first resistor (110) and the second resistor (210) have a resistance value that linearly changes depending on a temperature; and/or
the first resistor (110) and the second resistor (220) have a common resistance value at a common temperature; and/or
a number of capacitors included in the plurality of first capacitors (120) is equal to a number of capacitors included in the plurality of second capacitors (220), and a capacitance of each of the plurality of first capacitors (120) is equal to a capacitance of each of the plurality of second capacitors (220).

11. The temperature sensing method of claim 9 and claim 10, further comprising:
based on the first voltage being greater than the second voltage, outputting, at the SAR logic circuit (400), a third control signal to control a total capacitance value of the plurality of first capacitors (120) and the plurality of second capacitors (220) to decrease; and
based on the second voltage being greater than the first voltage, outputting, at the SAR logic circuit (400), the third control signal to control the total capacitance value of the plurality of first capacitors (120) and the plurality of second capacitors (220) to increase.

12. The temperature sensing method of claim 11, further comprising controlling a plurality of first switches (130) to electrically connect a ground voltage node to the plurality of first capacitors (120), respectively, and a plurality of second switches (230) to electrically connect the ground voltage node to the plurality of second capacitors (220), respectively.

13. The temperature sensing method of any of claims 9-12, wherein the first control signal and the second control signal have different levels in at least a portion of a time interval, and
wherein the plurality of first capacitors (120) and the plurality of second capacitors (220) perform a charging operation and a discharging operation differently from each other in the at least a portion of the time interval.

14. The temperature sensing method of claim 13, further comprising:
turning on a first control switch (140) electrically connected between the first node (ND1) and a power supply voltage node based on the first control signal, and turning on a third control switch (240) electrically connected between the second node (ND2) and a ground voltage node based on the first control signal; and
turning on a second control switch (150) electrically connected between the first resistor (110) and the first node (ND1) based on the second control signal, and turning on a fourth control switch (250) electrically connected between the second resistor (220) and the second node (ND2) based on the second control signal.

15. A system on chip (SoC) comprising:
a temperature sensing device according to any of claims 1-8; and
a processor core configured to receive the power supply voltage from a power management integrated circuit,
wherein the resistance value of the first resistor linearly changes based on a temperature of the processor core and the resistance value of the second resistor linearly changes based on the temperature of the processor core.
